(19) Europäisches Patentamt
European Patent Office
Office européen des brevets

(11) **EP 3 483 618 B1**

(12) **EUROPÄISCHE PATENTSCHRIFT**

(45) Veröffentlichungstag und Bekanntmachung des Hinweises auf die Patenterteilung:
**29.12.2021 Patentblatt 2021/52**

(51) Int Cl.:
*G01R 33/48* (2006.01)      *G01R 33/561* (2006.01)

(21) Anmeldenummer: **17200835.1**

(22) Anmeldetag: **09.11.2017**

(54) **VERFAHREN ZUR ERZEUGUNG EINES KOMBINATIONSBILDDATENSATZES AUS ZWEI MAGNETRESONANZBILDDATENSÄTZEN ZUR TRENNUNG ZWEIER SPINSPEZIES**

METHOD TO CREATE A COMBINATION IMAGE DATA SET FROM TWO MAGNETIC RESONANCE IMAGING DATA SETS FOR SEPARATING TWO SPIN SPECIES

PROCÉDÉ DE GÉNÉRATION D'UN ENREGISTREMENT D'IMAGE COMBINÉE DE DEUX ENREGISTREMENTS D'IMAGERIE PAR RÉSONANCE MAGNÉTIQUE POUR LA SÉPARATION DE DEUX TYPES DE SPINS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**15.05.2019 Patentblatt 2019/20**

(73) Patentinhaber: **Siemens Healthcare GmbH 91052 Erlangen (DE)**

(72) Erfinder:
• **PAUL, Dominik**
  **91088 Bubenreuth (DE)**
• **ZELLER, Mario**
  **91054 Erlangen (DE)**

(56) Entgegenhaltungen:
DE-B3-102014 215 896

• HOLGER EGGERS ET AL: "Chemical shift encoding-based water-fat separation methods", JOURNAL OF MAGNETIC RESONANCE IMAGING, Bd. 40, Nr. 2, 21. Januar 2014 (2014-01-21), Seiten 251-268, XP055443342, US ISSN: 1053-1807, DOI: 10.1002/jmri.24568
• ANANTH J. MADHURANTHAKAM ET AL: "T2-weighted 3D fast spin echo imaging with water-fat separation in a single acquisition", JOURNAL OF MAGNETIC RESONANCE IMAGING, Bd. 32, Nr. 3, 27. August 2010 (2010-08-27), Seiten 745-751, XP055475753, US ISSN: 1053-1807, DOI: 10.1002/jmri.22282
• Michael L. Lipton: "Manipulating k-Space: Rapid Acquisition with Relaxation Enhancement, Turbo Spin Echo, Fast Spin Echo" In: "Totally Accessible MRI : A User's Guide to Principles, Technology, and Applications", 1. Januar 2008 (2008-01-01), Springer New York, XP055477117, ISBN: 978-0-387-48895-0 Seiten 177-179, * Abschnitt "Manipulating k-Space: Rapid Acquisition with Relaxation Enhancement, Turbo Spin Echo, Fast Spin Echo" *

**EP 3 483 618 B1**

**Beschreibung**

Bei der Auswertung von Magnetresonanzexperimenten kann es notwendig sein, zwischen unterschiedlichen Spinspezies zu unterscheiden. Bei Protonen können in Lebewesen als Spinspezies beispielsweise Wasserprotonen und Fettprotonen differenziert werden.

Es ist möglich, eine räumliche Verteilung der Spinspezies zu erhalten, indem man spektroskopische Bilddaten akquiriert. Entsprechende Verfahren sind unter dem Akronym "CSI" bekannt.

CSI-Verfahren weisen den Nachteil auf, dass sie zeitraubend sind, da alle Raumrichtungen mit Phasenkodiergradienten kodiert werden. Geht es alleine um die Unterscheidung zwischen Wasser und Fett in den Bildern gibt es auch die Möglichkeit, ein Dixon-Verfahren anzuwenden. Unter Dixon-Verfahren werden Verfahren verstanden, bei denen zwei oder drei Bilddatensätze miteinander zu Kombinationsbildern kombiniert werden. Die Bilddatensätze sind mit bestimmten Ausrichtungen der Phasen der Spinspezies zueinander aufgenommen worden. In einem Bilddatensatz weisen die Spins die gleiche Phase auf, die sogenannte "in phase" Position. Man sagt auch, dass die Spins in Phase sind. In dem zweiten Bilddatensatz sind die Spezies "opposed phase". Dies wird auch gegenphasig genannt. Werden diese Bilder dann addiert bzw. substrahiert erhält man ein reines Wasserbzw. Fettbild. In aller Regel sind hierbei noch Informationen über das $B_0$-Feld zu berücksichtigen. Diese gehen als Phaseninformation ein.

Benutzt man zur Datenaufnahme Gradientenechos muss man die Echozeit so wählen, dass die Spins zum Zeitpunkt der Datenaufnahme oder genauer zum Zeitpunkt der Echomitte einmal "in phase" und einmal "opposed phase" ausgerichtet sind.

Diese Dauern sind bekannt. Die Formel zur Ermittlung der Dauer, in der die Spins von der Position "in phase" zu "opposed phase" wechseln, lautet:

$$\Delta t_{in-opp} = 1/(2*B_0*\gamma*3.4ppm).$$

Die Dauer sinkt mit steigender Feldstärke. Bei 0,5 T liegt sie bspw. bei 7,2 ms, bei 1,5 T bei 2,4 ms und bei 3 T nur noch bei 1,2 ms.

Soll beispielsweise aufgrund von Suszeptibilitätsartefakten ein Spinecho zur Akquisition verwendet werden, so kann dies für die Aufnahme mit der "in phase"-Position wie üblich durchgeführt werden. D.h. dass zwischen dem Anregungsimpuls und dem Refokussierungsimpuls und dem Refokussierungsimpuls und der Echomitte der gleiche Zeitabstand vorliegt. In diesem Fall fallen das durch den Refokussierungsimpuls erzeugte Spinecho und das durch den Lesegradienten erzeugte Gradientenecho zusammen.

Um bei einem spinechobasierten Aufnahmeverfahren eine "opposed phase"-Position zu erhalten kann nicht einfach die Echozeit verkürzt oder verlängert werden. Die Spins sind zum Zeitpunkt des Spinechos nämlich immer "in phase". Daher ist bei spinechobasierten Verfahren das Gradientenecho gegenüber dem Spinecho zu verschieben und das Gradientenecho aufzunehmen.

Verwendet man bipolare Gradienten kann die Aufnahme der Echos so gelegt werden, dass zuerst ein Gradientenecho in "opposed phase"-Position, dann ein Spin- und Gradientenecho in "in phase"-Position und danach evtl. ein zweites Gradientenecho wiederum in "opposed phase"-Position aufgenommen wird.

Das zweite Gradientenecho kann verwendet werden, um auch bei inhomogenen $B_0$-Feldern eine Trennung der Spinspezies zu erzielen. Dann können die Bilder mit dem 3-Punkt-Dixon-Verfahren weiterverarbeitet werden. Es ist bei Magnetresonanzanlagen nach dem Stand der Technik obsolet, weswegen insbesondere aufgrund der schnelleren Berechnung üblicherweise das 2-Punkt-Dixon-Verfahren zum Einsatz kommt.

Um die Messzeit zu verkürzen kann als spinechobasiertes Verfahren ein Turbospinecho verwendet werden. Unter einer Turbospinechosequenz versteht man eine Sequenz, bei der auf einen Anregungsimpuls mehrere Refokussierungsimpulse und eine entsprechende Anzahl an Echos folgen. Weitere Namen für Turbospinecho, das TSE abgekürzt wird, sind Fast Spin Echo mit der Abkürzung FSE oder Rapid Acquisition with Relaxation Enhancement, auch RARE genannt. Nach der Aufnahme eines Echos wird der Phasenkodiergradient weitergeschaltet, sodass in einem Echozug mehrere Echos und dabei mehrere k-Raum-Zeilen eines Bilddatensatzes aufgenommen werden.

Die Zeit zwischen zwei Echos in einem Echozug wird auch Interechozeit genannt. Die effektive Echozeit ist die Zeit, zu der die zentralen k-Raum-Zeilen aufgenommen werden. Es existieren nämlich unterschiedliche Aufnahmestrategien bei Turbospinechos. Zum Einen kann man am Anfang eines Echozuges die zentralen k-Raum-Zeilen abtasten und dann nach außen hin fortschreiten. In diesem Fall sind die Echozeit und die effektive Echozeit gleich.

Beginnt man mit dem Abtasten aber außen im k-Raum und geht dann in Richtung Zentrum und dann wieder nach außen, so liegt das Echo der zentralen k-Raum-Zeile an einer Position in der Mitte. Die effektive Echozeit ist dann sehr viel größer als die Echozeit.

Verwendet man ein Turbospinecho und bipolare Gradienten beim Auslesen der Echosignale kann man beide Bilddatensätze für ein 2-Punkt-Dixon-Verfahren ungefähr in der Zeit erhalten, in der man ein einfaches Turbospinecho aufnimmt.

Die DE 10 2014 215 896 B3 offenbart ein Verfahren zur Erzeugung eines Kombinationsbilddatensatzes unter Verwendung des Dixon-Verfahrens und paralleler Bildgebung. Zur Vermeidung von Artefakten wird vorgeschlagen, jeweils wechselseitig zur Rekonstruktion der parallelen Bilddatensätze Kalibrierungsdaten aus einem der anderen parallel aufgenommen Datensätze zu verwenden. Dabei werden die gleich- und gegenphasigen Daten mittels zweier Turbospinecho-Sequenzen erhalten.

Holger Eggers ET AL: "Chemical shift encoding-based water-fat separation methods", JOURNAL OF MAGNETIC RESONANCE IMAGING, Bd. 40, Nr. 2, 21. Januar 2014, Seiten 251-268 beschreibt verschiedene Varianten des Dixon-Verfahrens. Als Sequenzen sind Gradienten-Echo- und Spinecho-Sequenzen gezeigt. Diese können getrennt oder als Multi-Echo aufgenommen werden.

Ananth J. Madhuranthakam et al: "T2-weighted 3D fast spin echo imaging with water-fat separation in a single acquisition", JOURNAL OF MAGNETIC RESONANCE IMAGING, Bd. 32, Nr. 3, 27. August 201O, Seiten 745-751 betrifft ein Verfahren zur Aufnahme eines 3D-FSE-Bilddatensatzes, wobei Echosignale verschiedener Phasenstellungen der Wasser- und Fettprotonen zueinander aufgenommen werden, um eine Wasser-Fett-Separierung mit dem sogenannten IDEAL-Verfahren durchführen zu können.

Dabei besteht das Problem, dass bei geringen Feldstärken eine vergleichsweise lange Messzeit benötigt wird, da die Anzahl der Echos in einem Echozug auf weniger als 20 Echos, insbesondere 15 Echos, aufgrund von Signalverlusten beschränkt ist. Mit anderen Worten ist nach 15 Echos kein Signal mehr da, das gemessen werden könnte.

Die genaue Anzahl hängt von T2 ab und kann je nach Untersuchungsbereich variieren.

Es ist daher Aufgabe der vorliegenden Erfindung, ein Verfahren anzugeben, mit dem eine schnellere Durchführung eines Dixon-Verfahrens insbesondere bei niedrigen Feldstärken möglich ist.

Diese Aufgabe wird gelöst durch ein Verfahren zur Erzeugung wenigstens eines Kombinationsbilddatensatzes mit den Schritten:

- Aufnehmen eines ersten Bilddatensatzes mit einer ersten Turbospinechosequenz, wobei die gemessenen Echosignale so gelegt werden, dass die Spins zweier Spinspezies im Untersuchungsbereich in Phase sind,
- Aufnehmen eines zweiten Bilddatensatzes mit einer zweiten Turbospinechosequenz, wobei die gemessenen Echosignale so gelegt werden, dass die Spins zweier Spinspezies im Untersuchungsbereich gegenphasig sind,
- Kombination des ersten Bilddatensatzes und des zweiten Bilddatensatzes zu einem Kombinationsbild,

wobei die Turbospinechosequenzen jeweils eine Echozeit (TE) aufweisen, welche als die Zeit zwischen dem Anregungspuls und dem ersten Spinecho definiert ist, und wobei die Turbospinechosequenzen jeweils eine Interechozeit (TI) aufweisen, welche als die Zeit zwischen zwei Spinechos in einem Echozug definiert ist, dadurch gekennzeichnet, dass

- die Echozeit und/oder die Interechozeit bei der ersten Turbospinechosequenz kleiner ist als bei der zweiten Turbospinechosequenz.

Als Kern der Erfindung wird dabei angesehen, die Bilddaten für ein Dixon-Verfahren getrennt und jeweils mit einer Turbospinechosequenz aufzunehmen. Dadurch können die Turbospinechosequenzen jeweils für die aufzunehmenden Messdaten optimiert werden. Insgesamt erhält man, obwohl die Sequenzen hintereinander ausgeführt werden, eine geringere Messzeit als bei der Verwendung eines Gradientenechozuges.

Bei der Aufnahme des zweiten Bilddatensatzes entstehen, wie später auch noch gezeigt wird, Spinechos. Bei diesen sind die Spins in Phase. Diese Echos werden jedoch nicht akquiriert.

Dabei gelten für das erfindungsgemäße Verfahren die Ausführungen zu den bekannten Turbospinechosequenzen weiter. Die Turbospinechosequenzen weisen also mehrere Refokussierungsimpulse in einem Anregungszug auf.

Als Messsequenz wird wie üblich eine Abfolge von HF-Impulsen, Gradientenfeldern, Wartezeiten und Akquisitionsfenstern bezeichnet, die den Ablauf der Messsequenz genau festlegen und charakterisieren. Eine Turbospinechosequenz ist eine derartige Messsequenz.

Eine Messsequenz besteht dabei aus definierten oder definierbaren Teilexperimenten. Ein Teilexperiment kann auch Anregungszyklus genannt werden. Bei einem Spinecho werden so viele Anregungsimpulse angelegt wie phasenkodierende Schritte durchgeführt werden. Entsprechend gibt es so viele Anregungszyklen wie phasenkodierende Schritte.

Bei einem Turbospinecho, werden in einem Anregungszyklus mehrere Refokussierungsimpulse angelegt, weswegen wie bereits ausgeführt von einem Echozug gesprochen wird. In der vorliegenden Erfindung wird dabei zwischen einem Echozug aufgrund mehrerer Refokussierungsimpulse und einem Gradientenechozug aufgrund von Lesegradienten, insbesondere bipolaren Lesegradienten, unterschieden. Bei einem Turbospinecho mit 128 Phasenkodierschritten und einer Anzahl von 8 Echos in einem Echozug ergibt sich damit eine Zahl von nur 16 Anregungszyklen zur Aufnahme eines vollständigen Messdatensatzes.

Die Länge eines Anregungszyklus wird Repetitionszeit genannt und "TR" abgekürzt.

Diese Ausführungen sollen lediglich die bestehenden fachmännischen Konventionen erläutern.

Es versteht sich außerdem, dass unter der Aufnahme eines Bilddatensatzes verstanden wird, Messsignale aufzunehmen und diese zu einem Bild zu prozessieren. Dabei werden die Messsignale zumindest fouriertransformiert.

Weiter oben war ausgeführt worden, dass eine Messsequenz wie eine Turbospinechosequenz durch die Abfolge von HF-Impulsen, Gradientenfeldern, Wartezeiten und Akquisitionsfenstern definiert sei. Dabei ist zu beachten, dass hierbei bestimmte Variationsmöglichkeiten bestehen. Der Refokussierungsimpuls kann von Spoilergradienten umgeben sein, muss es aber nicht. Der Phasenkodiergradient kann vor oder nach dem Refokussierungsgradient liegen, ebenso wie der Lese-Dephasiergradient. Bei einer Turbospinechosequenz ist es oft bevorzugt, wenn diese vor dem Refokussierungsimpuls liegen. Dies hat allerdings keine physikalischen Gründe, vielmehr verringert dies den Programmieraufwand. Der Teil um den Refokussierungsimpuls kann dann als sich wiederholendes Modul programmiert werden.

Der Lesegradient wird wenigstens einmal nach jedem Refokussierungsimpuls angelegt. Er ermöglicht bekanntermaßen eine ortsabhängige Kodierung.

Es werden also kurz zusammenfassend zwei Bilddatensätze mittels zweier Turbospinechosequenzen aufgenommen, wobei bei dem ersten Bilddatensatz die Spins der Spinspezies in Phase sind und bei dem zweiten gegenphasig.

Vorteilhafterweise werden bei der Aufnahme des ersten Bilddatensatzes ausschließlich Spinechosignale akquiriert.

Diese fallen bei der Bildgebung immer mit Gradientenechosignalen zusammen, werden aber als Spinechosignale bezeichnet.

Vorteilhafterweise werden bei der Aufnahme des zweiten Bilddatensatzes ausschließlich Gradientenechosignale akquiriert.

Vorteilhafterweise können bei der Aufnahme des zweiten Bilddatensatzes nach dem Anlegen zumindest eines

Refokussierungsimpulses wenigstens zwei Echosignale aufgenommen werden. Das heißt, dass mehr als ein Gradientenecho pro Refokussierungsimpuls vorliegt.

Vorzugsweise können die Echosignale durch bipolare Gradienten erzeugt werden. Als bipolare Gradienten werden in der vorliegenden Erfindung Gradienten unterschiedlicher Polarität angesehen. Es muss sich nicht um zwei zeitlich beabstandete Gradienten handeln, es kann sich auch um einen Gradientenzug mit Gradienten wechselnder Polarität handeln. Insbesondere können drei Gradienten in Leserichtung angelegt werden, von denen zwei eine erste Polarität und der dritte, in der Mitte liegende, Gradient die andere Polarität aufweist. Dieser in der Mitte liegende Gradient ist lediglich notwendig um mit dem dritten Gradienten das zweite reine Gradientenecho erzeugen zu können.

Vorteilhafterweise können die gemessenen Echosignale durch Gradienten gleicher Polarität erzeugt werden. Im zweiten Bilddatensatz werden die Spinspezies in gegenphasiger Stellung ausgemessen. Nachdem diese durch Gradientenechos gemessen werden, da die Spinspezies wie bereits beschrieben zum Zeitpunkt eines Spinechos in der "in Phase"-Stellung sind, können bei drei Gradienten abwechselnder Polarität die gewünschten Echos beim ersten und dritten Gradienten erhalten werden.

Vorzugsweise können die beiden Echosignale Teile eines einzigen Bilddatensatzes sein. Es handelt sich immer noch um die Gradientenechos, die nach einem Refokussierungsimpuls akquiriert werden. Zwischen diesen ist ein zusätzlicher Phasenkodiergradient anzulegen, um die k-Raum-Zeile zu wechseln. Dann können in einem Echozug doppelt so viele Gradientenechos, d.h. k-Raum-Zeilen, aufgenommen werden wie Refokussierungsimpulse angelegt werden.

Führt man das obige Beispiel fort, so können in einem Anregungszyklus statt 8 nunmehr 16 Gradientenechos aufgenommen werden. Die Zahl der Anregungszyklen bei der Aufnahme des zweiten Bilddatensatzes halbiert sich dadurch auf 8. Das dazwischen entstehende Spinecho wird nicht aufgenommen.

Dadurch kann der zweite Gradient der drei bipolaren Gradienten mit einer hohen Gradientenstärke und dafür kurzer Dauer geschaltet werden. Somit können der erste und der dritte Gradient und damit die Gradientenechos näher an das in der Mitte liegende Spinecho gerückt werden.

Vorteilhafterweise kann bei der Aufnahme des ersten Bilddatensatzes eine höhere Anzahl von Refokussierungsimpulsen in einem Echozug angelegt werden als bei der Aufnahme des zweiten Bilddatensatzes. Dadurch dass bei der Aufnahme der in der "in Phase" befindlichen Spins keine zusätzlichen Gradientenechos aufzunehmen sind kann die Echozeit und auch die Interechozeit minimiert werden. Dann können bei selbstverständlich gleichbleibendem T2 mehr Refokussierungsimpulse und damit mehr Spinechos erzeugt werden.

Was sich allerdings nicht sagen lässt ist, dass bei der Aufnahme des ersten Bilddatensatzes in einem Anregungszyklus und damit Echozug mehr Echos aufgenommen werden. Zwar können mehr Refokussierungsimpulse angelegt werden. Durch diese wird allerdings jeweils ein einziges Spinecho erzeugt. Bei der Aufnahme des zweiten Bilddatensatzes können dagegen auch zwei Gradientenechos pro Refokussierungsimpuls akquiriert werden. Die Anzahl der aufgenommenen Echos pro Anregungszyklus kann also bei der Aufnahme des zweiten Bilddatensatzes höher sein obwohl weniger Refokussierungsimpulse in einem Anregungszyklus angelegt werden.

Dabei ist die Echozeit und/oder die effektive Echozeit und/oder die Interechozeit bei der Aufnahme des ersten Bilddatensatzes kleiner als bei der Aufnahme des zweiten Bilddatensatzes. Man muss hier noch berücksichtigen, dass bei der Aufnahme des zweiten Bilddatensatzes mehrere Echozeiten vorliegen können, nämlich für den Fall, dass zwei Gradientenechos pro Refokussierungsimpuls akquiriert werden. Eines der Gradientenechos ist gegenüber den bei der Aufnahme des zweiten Bilddatensatzes erzeugten Spinechos vorgezogen, d.h. es hat eine kleinere Echozeit als das Spinecho der zweiten Turbospinechosequenz. Trotzdem kann durch die Optimierung der ersten Turbospinechosequenz erreicht werden, dass bei der Aufnahme des ersten Bilddatensatzes und damit bei der ersten Turbospinechosequenz die kürzeste Echozeit und/oder Interechozeit vorliegt.

Vorzugsweise kann die Echozeit und/oder die effektive Echozeit und/oder die Interechozeit bei der Aufnahme des ersten Bilddatensatzes minimiert werden. Minimieren heißt, dass bei der Berechnung der Wartezeiten, auch Delays genannt, eine Minimierung, d.h. eine kürzestmögliche Zeit, im Vordergrund steht. Es wird also nicht eine vorgegebene Echozeit und/oder effektive Echozeit und/oder Interechozeit z.B. zur Erzeugung eines gewünschten Kontrastes angestrebt sondern die kürzestmögliche. In Bezug auf die Interechozeit heißt das, keine unnötigen Delays vorzusehen, die Gradienten kürzestmöglich zu schalten, etc.

Vorteilhafterweise kann die Differenz der effektiven Echozeiten bei der Aufnahme des ersten Bilddatensatzes und des zweiten Bilddatensatzes kleiner oder gleich der Zeit sind, die die Spins der Spinspezien benötigen, um von der "in Phase"-Position in die gegenphasige Position zu gelangen. Eine kleine Differenz kann notwendig sein, wenn die Sequenzparameter und insbesondere die Verschiebung des Gradientenechos im Vergleich zum Spinecho dies erzwingen. Es wird hierdurch ein möglichst vergleichbares SNR erhalten.

Vorzugsweise können die Bilddatensätze mittels einer Addition zu einem Kombinationsbild kombiniert werden. Alternativ können die Bilddatensätze durch eine Subtraktion zu einem Kombinationsbild kombiniert werden. Dabei können jeweils Informationen über das $B_0$-Magnetfeld berücksichtigt werden. Beispielsweise kann eine $B_0$-Karte verwendet werden oder eine Signalintensitätsoptimierung erfolgen. In allen Fällen werden die Bilddatensätze vorteilhafterweise pixelweise kombiniert.

Vorteilhaferweise weisen die Bilddatensätzen eine identische Auflösung und/oder identische Schichtdicke und/oder ein identisches FoV auf. Dadurch ist die Prozessierung bzw. die Durchführung des Dixon-Verfahrens vereinfacht, da Korrekturen wegfallen.

Bei der Aufnahme der Bilddatensätze können eine Bodycoil und/oder ein Spulenarray verwendet werden. Insbesondere können die Turbospinechos zur weiteren Beschleunigung mittels paralleler Bildgebung aufgenommen und ausgewertet werden.

Vorteilhafterweise können zur Vermeidung von Bewegungsartefakten Navigatorechos verwendet werden.

Vorzugsweise kann das Verfahren in einer Magnetresonanzanlage mit einer Feldstärke kleiner als 1,5 T durchgeführt werden. Wie beschrieben ist das Verfahren insbesondere bei inhomogenen Magnetfeldern und geringen Feldstärken vorteilhaft.

Bevorzugt kann das Verfahren an einer Magnetresonanzanlage mit einer offenen Architektur durchgeführt werden. Diese haben keinen ringförmigen Querschnitt, sondern eine Anordnung, bei der bspw. der Kopf eines Patienten "frei" liegt.

Vorzugsweise kann gleichzeitig zum Anregungsimpuls und/oder Refokussierungsimpuls bzw. den Refokussierungsimpulsen jeweils ein Schichtauswahlgradient anliegen. Dieser ermöglicht eine schichtselektive Anregung der Spins. Vorzugsweise kann nach dem Auslesen der Echosignale ein Phase-Rewind-Gradient angelegt werden. Dieser soll die Magnetisierung wieder in die Mitte des k-Raums bringen.

Die Lösung der eingangs genannten Aufgabe wird außerdem durch ein Computerprogrammprodukt bzw. ein Computerprogramm erzielt, das zur Steuerung einer Steuerungseinrichtung eingesetzt werden kann, welche eine Bilderzeugungseinheit einer Magnetresonanzanlage steuert, welches das vorgenannte erfindungsgemäße Verfahren ausführt.

Daneben betrifft die Erfindung einen Datenträger für eine Steuerungseinrichtung zur Steuerung einer Datenerzeugungseinheit einer Magnetresonanzanlage mit Daten zum Durchführen des beschriebenen Verfahrens. Vorteilhafterweise kann die Datenerzeugungseinheit eine Bilderzeugungseinheit sein.

Daneben betrifft die Erfindung eine Magnetresonanzanlage mit einer Steuerungseinrichtung. Die Magnetresonanzanlage zeichnet sich dadurch aus, dass die Steuerungseinrichtung zur Durchführung des Verfahrens wie beschrieben ausgebildet ist.

Die Implementierung der vorgenannten Verfahren in der Steuervorrichtung kann dabei als Software oder aber auch als (fest verdrahtete) Hardware erfolgen.

Weitere vorteilhafte Ausgestaltungen der erfindungsgemäßen Magnetresonanzanlage korrespondieren zu entsprechenden Ausgestaltungen des erfindungsgemäßen Verfahrens. Zur Vermeidung unnötiger Wiederholungen wird somit auf die entsprechenden Verfahrensmerkmale und deren Vorteile verwiesen.

Weitere Vorteile, Merkmale und Besonderheiten der vorliegenden Erfindung ergeben sich aus der nachfolgenden Beschreibung vorteilhafter Ausgestaltungen der Erfindung.

Dabei zeigen:

Fig. 1    eine Magnetresonanzanlage,

Fig. 2    eine Messsequenz (Stand der Technik),

Fig. 3    eine erste Messsequenz,

Fig. 4    eine zweite Messsequenz in einer ersten Ausgestaltung, und

Fig. 5    die zweite Messsequenz in einer zweiten Ausgestaltung.

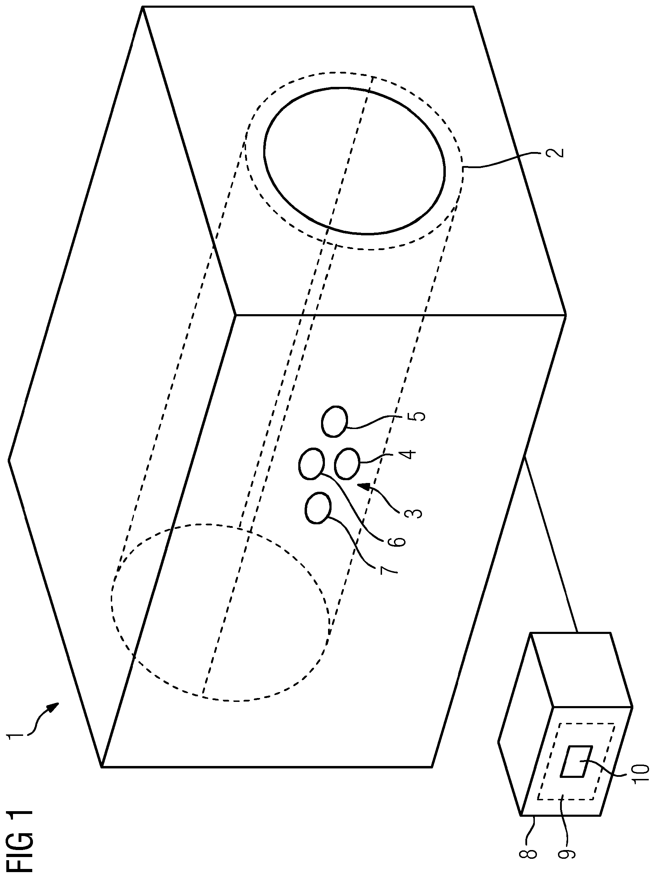

Figur 1 zeigt eine Magnetresonanzanlage 1 mit einer Sendespulenanordnung 2. Die Sendespulenanordnung 2 kann als Bodycoil ausgestaltet sein. Es kann sich dabei aber auch um ein Sendespulenarray handeln. Die Sendespulenanordnung 2 ist gestrichelt dargestellt.

Zur Datenakquisition besitzt die Magnetresonanzanlage 1 eine Empfangsspulenanordnung 3. Die Empfangsspulenanordnung 3 ist vorzugsweise als Spulenarray mit Spulen 4, 5, 6 und 7 ausgestaltet. Die Spulen 4, 5, 6 und 7 lesen Messsignale parallel aus. Zur Prozessierung werden dann bekannte Entfaltungsverfahren wie GRAPPA oder SENSE verwendet.

Zur Steuerung der Messabläufe weist die Magnetresonanzanlage 1 eine Steuerungseinrichtung 8 auf.

Die Magnetresonanzanlage 1 besitzt weiterhin einen Datenträger 9 als Teil der Steuerungseinrichtung 8 oder unabhängig davon, auf dem Computerprogramme 10 zur Durchführung von Magnetresonanzmessungen abgespeichert sind.

Weitere Bestandteile der Magnetresonanzanlage 1 wie bspw.

Gradientenspulen oder eine Patientenliege sind der Übersichtlichkeit halber nicht dargestellt.

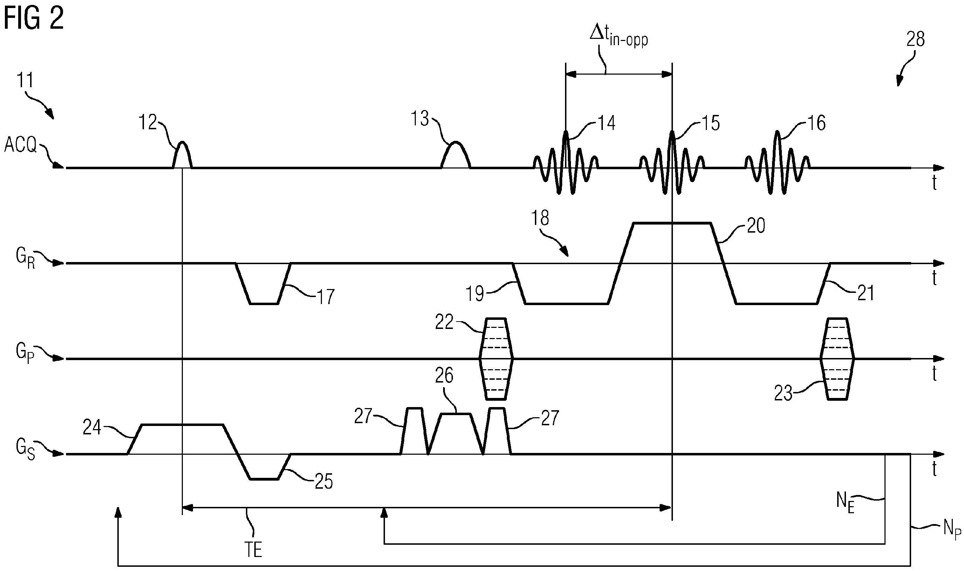

Figur 2 zeigt eine bekannte Messsequenz zur Erzeugung dreier Bilddatensätze für ein 3-Punkt-Dixon-Verfahren.

Dabei wird ein Turbospinecho durch einen Gradientenechozug so erweitert, dass mit einer Messsequenz drei Bilddatensätze erhalten werden.

Das Sequenzdiagramm 11 des Turbospinechos zeigt in der Akquisitionszeile ACQ einen Anregungsimpuls 12, einen Refokussierungsimpuls 13, zwei Gradientenechos 14 und 16 sowie ein Spinecho 15. Das Spinecho 15 ist genau genommen ein Spinecho und ein Gradientenecho gleichzeitig. Der besseren Unterscheidung wegen wird es im Folgenden lediglich als Spinecho bezeichnet.

Der Abschnitt ab dem Refokussierungsimpuls 13 wird so oft wiederholt wie Spinechos in einem Echozug erzeugt werden sollen. Diese Anzahl wird mit den Buchstaben $N_E$ bezeichnet.

In Leserichtung $G_R$ liegen ein Lese-Dephasiergradient 17 und ein Gradientenechozug 18 mit drei Lesegradienten 19, 20 und 21 an. Die Lesegradienten 19 und 21 erzeugen die Gradientenechos 14 und 16, die so gelegt sind, dass die Spins der Wasser- und Fettprotonen "opposed phase" liegen. Die Formel zur Berechnung des Zeitabstandes wurde anfangs genannt.

In Phasenrichtung $G_P$ liegt ein Phasenkodiergradient 22 an. Dieser ist bevorzugt nach dem Refokussierungsimpuls 13 angeordnet. Nach dem Gradientenechozug 18 folgt ein Phasengradient 23, mit dem die Phase wieder zurückgestellt wird. Mit anderen Worten wird in die k-Raum-Mitte zurückgegangen. Die Amplitude der Gradienten 22 und 23 hängt dabei davon ab ob bei der Erzeugung des ersten Echos eine anfängliche k-Raum-Position eingenommen wird oder ab dem zweiten Echo feste Schritte durch den k-Raum erfolgen.

In Schichtrichtung $G_S$ folgt auf einen Schichtauswahlgradienten 24 und ein Schicht-Rephasiergradient 25. Diese dienen der Schichtselektion während des Anregungsimpulses 12 und der Rephasierung der Spins. Während des Refokussierungsimpulses 13 liegt ebenfalls ein Schichtauswahlgradient 26 an. Zusätzlich ist der Refokussierungsimpuls 13 von Spoilergradienten 27 umgeben. Diese dienen zum Spoilen von Imperfektionen des Refokussierungsimpulses 13.

Über die Refokussierungsimpulse 13 und die Spinechos 15 ist die Interechozeit TI definiert. Diese entspricht zumeist der Echozeit TE, muss aber nicht. Die effektive Echozeit $TE_{eff}$ ergibt sich dagegen über den Anregungsimpuls 12 und das Echo 14 oder 15 der zentralen k-Raum-Zeile.

Mit Np wird die sich ergebende Anzahl an Anregungszyklen bezeichnet. Sie ist maximal gleich groß wie die Anzahl der phasenkodierenden Schritte, üblicherweise aber viel kleiner. Zum einen sinkt sie aufgrund der mehreren in einem Zug aufgenommenen Echos, zum anderen wird bei paralleler Bildgebung nur ein Teil der Phasenkodierschritte real vorgenommen.

Mit den mittels der im Sequenzdiagramm 11 dargestellten Messsequenz 28 aufgenommenen Bilddatensätze können in einem 3-Punkt-Dixon-Verfahren ein Wasserbild und/oder ein Fettbild gewonnen werden.

Bei geringen Feldstärken, d.h. Feldstärken kleiner als 1,5 T, und insbesondere bei offenen Architekturen bedingt das beschriebene Vorgehen lange Messzeiten.

Um diese zu vermeiden wird folgendes Verfahren angewandt:

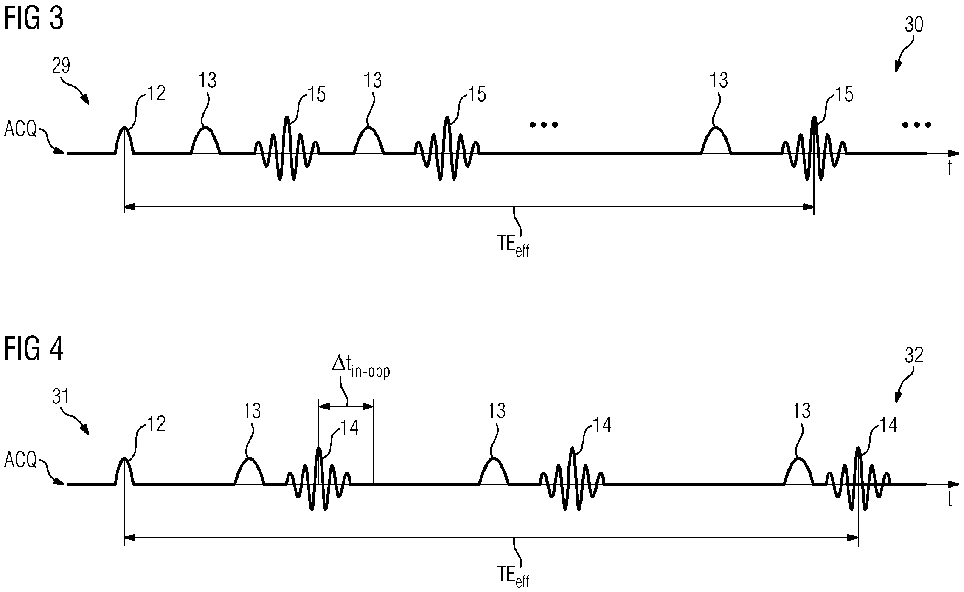

Figur 3 zeigt einen Teil eines Sequenzdiagramms 29 einer Messsequenz 30. Die Messsequenz 30 ist eine Turbospinechosequenz. Von dieser ist lediglich die Akquisitionszeile ACQ gezeigt. Bei der Messsequenz 30 werden lediglich Spinechos 15 akquiriert. Ansonsten werden alle Wartezeiten eliminiert, sodass eine maximale Anzahl an Echos in einem Echozug aufgenommen werden kann. Auf diese Weise können bspw. statt fünfzehn Spinechos in einem Echozug vierundzwanzig Spinechos in einem Echozug aufgenommen werden.

Im Vergleich zu Figur 2 sind lediglich die Lesegradienten 19 und 21 wegzulassen und die Interechozeit TI zu minimieren, um den beschriebenen Erfolg zu erzielen.

Zur Verdeutlichung wird nochmals klargestellt, dass mit der Messsequenz 30 die k-Raum-Zeilen für einen Bilddatensatz gewonnen werden, bei dem die Spins von Wasser- und Fettprotonen oder allgemeiner zweier Spinspezies "in Phase" sind.

Figur 4 zeigt einen Teil eines Sequenzdiagramms 31 einer weiteren Messsequenz 32. Auch die Messsequenz 32 ist eine Turbospinechosequenz. Diese dient der Aufnahme von Gradientenechos 14 und damit von Messdaten, bei denen die Spins zweier Spinspezies gegenphasig ausgerichtet sind. Wie in Figur 3 ist lediglich die Akquisitionszeile ACQ gezeigt.

Die Lesegradienten 20 und 21 können weggelassen oder geschaltet werden. Das Spinecho 15 entsteht zwar, es wird aber nicht ausgelesen. Ansonsten kann die Messsequenz 32 wie die Messsequenz 28 ausgestaltet werden. Das Gradientenecho 16 wird erzeugt und ausgelesen, wenn es für ein 3-Punkt-Dixon-Verfahren verwendet werde soll.

Statt einer Messsequenz 28 werden also zwei optimierte Messsequenzen 30 und 32 verwendet. Ein Vergleich der Figuren 3 und 4 zeigt dabei, dass die Interechozeit TI bei der Messsequenz 30 und dabei bei der Sequenz zum Aufnehmen des ersten Bilddatensatzes kürzer ist als bei der Messsequenz 32, die zur Aufnahme des zweiten Bilddatensatzes dient. Auch die Echozeit TE ist bei der Messsequenz 30 kürzer.

Die effektive Echozeit $TE_{eff}$ ist ungefähr gleich lang. Die Differenz ist maximal so lang wie der Zeitabstand $\Delta t_{in-opp}$.

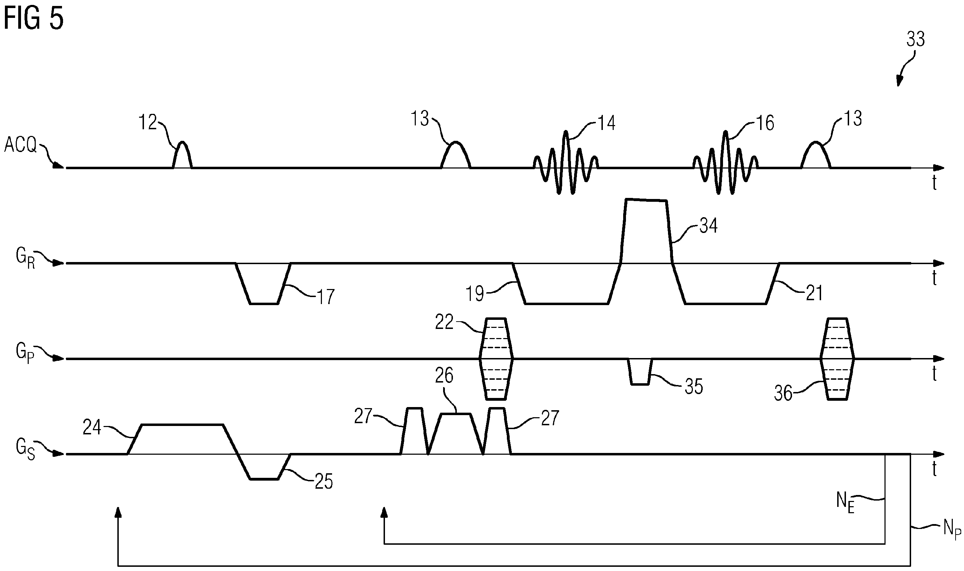

Figur 5 zeigt eine alternative Ausgestaltung der Messsequenz 32 aus Figur 4 in Form der Messsequenz 33. Dabei sind neben der Akquisitionszeile ACQ auch die Gradienten gezeigt. Im Unterschied zu Figur 4 befindet sich zwischen den Lesegradienten 19 und 21 ein Gradient 34. Dieser besitzt zwar die gleiche Fläche wie die Gradienten 19 und 21, er ist aber stärker und kürzer geschaltet. Dadurch können die Lesegradienten 19 und 21 näher zur Echomitte des Spinechos 15 hin verschoben werden. Der Gradient 33 kann auch Flyback-Gradient genannt werden. Da das Spinecho 15 nicht ausgelesen wird kodiert der Gradient 34 keine Ortsinformation und kann daher beliebig ausgestaltet werden.

Parallel zum Gradient 34 kann in Phasenrichtung ein Phasengradient 35 angelegt werden. Dieser sorgt für ein Weitergehen um eine definierte Anzahl an k-Raum-Zeilen im k-Raum. Dadurch kann mit dem Gradientenecho 16 eine weitere Zeile des zweiten Bilddatensatzes erhalten werden. Somit können zwei k-Raum-Zeilen pro Refokussierungsimpuls und damit doppelt so viele Gradientenechos wie Spinechos im Echozug erhalten werden.

Der Phasengradient 36 ist ein Phase-Rewinder, der in der gezeigten Ausgestaltung die Differenzfläche zwischen Phasenkodiergradient 22 und Phasengradient 35 besitzt.

Insgesamt ergeben die Messsequenzen 30 und 32 oder 30 und 33 ein "in Phase"-Bild und ein gegenphasiges Bild, die durch Addition oder Subtraktion zu jeweils einem Kombinationsbild als Wasserbild oder Fettbild kombinieren lassen.

**Patentansprüche**

1. Verfahren zur Erzeugung wenigstens eines Kombinationsbilddatensatzes mit den Schritten:

    - Aufnehmen eines ersten Bilddatensatzes mit einer ersten Turbospinechosequenz (30), wobei die Echosignale (15) so gelegt werden, dass die Spins zweier Spinspezies im Untersuchungsbereich in Phase sind,
    - Aufnehmen eines zweiten Bilddatensatzes mit einer zweiten Turbospinechosequenz (32, 33), wobei die Echosignale (14, 16) so gelegt werden, dass die Spins zweier Spinspezies im Untersuchungsbereich gegenphasig sind,
    - Kombination des ersten Bilddatensatzes und des zweiten Bilddatensatzes zu einem Kombinationsbild,

    wobei die Turbospinechosequenzen jeweils eine Echozeit (TE) aufweisen, welche als die Zeit zwischen dem Anregungspuls und dem ersten Spinecho definiert ist, und wobei die Turbospinechosequenzen jeweils eine Interechozeit (TI) aufweisen, welche als die Zeit zwischen zwei Spinechos in einem Echozug definiert ist, **dadurch gekennzeichnet, dass**

    - die Echozeit (TE) und/oder die Interechozeit (TI) bei der ersten Turbospinechosequenz (30) kleiner ist als bei der zweiten Turbospinechosequenz (32, 33).

2. Verfahren nach Anspruch 1, **dadurch gekennzeichnet, dass** bei der Aufnahme des zweiten Bilddatensatzes nach dem Anlegen zumindest eines Refokussierungsimpulses (13) wenigstens zwei Echosignale (14, 16), insbesondere Gradientenechos (14, 16), aufgenommen werden.

3. Verfahren nach Anspruch 2, **dadurch gekennzeichnet, dass** beide Echosignale (14, 16) Teile eines einzigen Bilddatensatzes sind.

4. Verfahren nach einem der Ansprüche 2 oder 3, **dadurch gekennzeichnet, dass** die Echosignale (14, 16) durch bipolare Gradienten (19, 20, 21) erzeugt werden.

5. Verfahren nach einem der Ansprüche 2 oder 3, **dadurch gekennzeichnet, dass** die Echosignale (14, 16) durch Gradienten (19, 21) gleicher Polarität erzeugt werden.

6. Verfahren nach einem der vorangehenden Ansprüche, **dadurch gekennzeichnet, dass** bei der Aufnahme des ersten Bilddatensatzes eine höhere Anzahl von Refokussierungsimpulsen (13) in einem Echozug angelegt wird als bei der Aufnahme des zweiten Bilddatensatzes.

7. Verfahren nach einem der vorangehenden Ansprüche, **dadurch gekennzeichnet, dass** die Echozeit (TE) und/oder die effektive Echozeit ($TE_{eff}$) und/oder die Interechozeit (TI) bei der ersten Turbospinechosequenz (30) minimiert werden.

8. Verfahren nach einem der vorhergehenden Ansprüche, **dadurch gekennzeichnet, dass** die Differenz der effektiven Echozeiten ($TE_{eff}$) zwischen der ersten Turbospinechosequenz (30) und der zweiten Turbospinechosequenz (32, 33) kleiner oder gleich der Zeit ($\Delta t_{in\text{-}opp}$) ist, die die Spins der Spinspezien benötigen, um von der Position in Phase in die gegenphasige Position zu gelangen.

9. Verfahren nach einem der vorhergehenden Ansprüche, **dadurch gekennzeichnet, dass** es an einer Magnetresonanzanlage mit einer Feldstärke kleiner als 1,5 T durchgeführt wird.

10. Verfahren nach einem der vorhergehenden Ansprüche, **dadurch gekennzeichnet, dass** die Echosignale (14, 15, 16) mit einem Spulenarray (3) aufgenommen werden.

11. Computerprogrammprodukt (10) für eine Steuerungseinrichtung (8) zur Steuerung einer Datenerzeugungseinheit, insbesondere einer Bilderzeugungseinheit, einer Magnetresonanzanlage, umfassend Befehle, die bei der Ausführung des Programms durch die Steuerungseinrichtung diese veranlassen, ein Verfahren gemäß einem der vorhergehenden Ansprüche auszuführen.

12. Datenträger (9) für eine Steuerungseinrichtung (8) zur Steuerung einer Datenerzeugungseinheit, insbesondere Bilderzeugungseinheit, einer Magnetresonanzanlage (1), umfassend Befehle, die bei der Ausführung durch die Steuerungseinrichtung diese veranlassen, ein Verfahren gemäß einem der Ansprüche 1 bis 10 auszuführen.

13. Magnetresonanzanlage (1) mit einer Steuerungseinrichtung (8), **dadurch gekennzeichnet, dass** die Steuerungseinrichtung (8) zur Durchführung eines Verfahrens nach einem der Ansprüche 1 bis 10 ausgebildet ist.

**Claims**

1. Method for generating at least one combination image dataset, with the steps:

    - Recording of a first image dataset with a first turbo spin echo sequence (30), wherein the echo signals (15) are placed so that the spins of two spin species in the region to be examined are in-phase,
    - Recording of a second image dataset with a second turbo spin echo sequence (32, 33), wherein the echo signals (14, 16) are placed so that the spins of two spin species in the region to be examined are opposed phase,
    - Combination of the first image dataset and the second image dataset into a combination image, wherein the turbo spin echo sequences each have an echo time (TE) which is defined as the time between the excitation pulse and the first spin echo, and wherein the turbo spin echo sequences each have an interecho time (TI), which is defined as the time between two spin echos in an echo train,

    **characterised in that**

    - the echo time (TE) and/or the interecho time (TI) is smaller during the first turbo spin echo sequence (30) than during the second turbo spin echo sequence (32, 33).

2. Method according to claim 1, **characterised in that**, during the recording of the second image dataset, after the application of at least one refocusing pulse (13), at least two echo signals (14, 16), in particular gradient echoes (14, 16), are recorded.

3. Method according to claim 2, **characterised in that** both echo signals (14, 16) are parts of a single image dataset.

4. Method according to one of claims 2 or 3, **characterised in that** the echo signals (14, 16) are generated by bipolar gradients (19, 20, 21).

5. Method according to one of claims 2 or 3, **characterised in that** the echo signals (14, 16) are generated by gradients (19, 21) of the same polarity.

6. Method according to one of the preceding claims, **characterised in that** during the recording of the first image dataset, a higher number of refocusing pulses (13) are applied in an echo train than during the recording of the second image dataset.

7. Method according to one of the preceding claims, **characterised in that** the echo time (TE) and/or the effective echo time ($TE_{eff}$) and/or the interecho time (TI) is minimized during the first turbo spin echo sequence (30).

8. Method according to one of the preceding claims, **characterised in that** the difference of the effective echo times ($TE_{eff}$) between the first turbo spin echo sequence (30) and the second turbo spin echo sequence (32, 33) is less than or equal to the time ($\Delta t_{in\text{-}opp}$) that the spins of the spin species need to get from the in-phase position into the opposed-phase position.

9. Method according to one of the preceding claims, **characterised in that** it is carried out on a magnetic resonance system with a field strength of smaller than 1.5 T.

10. Method according to one of the preceding claims, **characterised in that** the echo signals (14, 15, 16) are recorded with a coil array (3).

11. Computer program product (10) for a control device (8) for controlling a data generation unit, in particular an image generation unit, of a magnetic resonance system (1), comprising commands which, with the execution of the program by the control device, trigger this to carry out a method according to one of the preceding claims.

12. Data medium (9) for a control device (8) for controlling a data generation unit, in particular an image generation unit, of a magnetic resonance system (1), comprising commands, which, with the execution by the control device, trigger this to carry out a method according to one of claims 1 to 10.

13. Magnetic resonance system (1) with a control device (8), **characterised in that** the control device (8) is embodied for carrying out a method according to one of claims 1 to 10.


## Revendications

1. Procédé de production d'au moins un ensemble de données d'image de combinaison comprenant les stades :

    - enregistrement d'un premier ensemble de données d'image avec une première séquence (30) d'écho de turbospin, dans lequel on met les signaux (15) d'écho de manière à ce que les spins de deux espèces de spin dans la partie à examiner soient en phase,
    - enregistrement d'un deuxième ensemble de données d'image avec une deuxième séquence (32, 33) d'écho de turbospin, dans lequel on met les signaux (14, 16) d'écho de manière à ce que les spins de deux espèces de spin dans la partie à examiner soient en opposition de phase,
    - combinaison du premier ensemble de données d'image et du deuxième ensemble de données d'image en une image de combinaison,

    dans lequel les séquences d'écho de turbospin ont chacune un temps (TE) d'écho, qui est défini comme le temps entre l'impulsion d'excitation et le premier écho de spin, et dans lequel les séquences d'écho de turbospin ont chacune un temps (TI) entre les échos, qui est défini comme le temps entre deux échos de spin d'un train d'échos, **caractérisé en ce que**

    - le temps (TE) d'écho et/ou le temps (TI) entre les échos est plus petit dans la première séquence (30) d'écho de turbospin que dans la deuxième séquence (32, 33) d'écho de turbospin.

2. Procédé suivant la revendication 1, **caractérisé en ce que**, lors de l'enregistrement du deuxième ensemble de données d'image, après l'application d'au moins une impulsion (13) de refocalisation, on enregistre au moins deux signaux (14, 16) d'écho, notamment des échos (14, 16) de gradient.

3. Procédé suivant la revendication 2, **caractérisé en ce que** les deux signaux (14, 16) d'écho font partie d'un seul ensemble de données d'image.

4. Procédé suivant l'une des revendications 2 ou 3, **caractérisé en ce que** l'on produit des signaux (14, 16) d'écho par des gradients (19, 20, 21) bipolaires.

5. Procédé suivant l'une des revendications 2 ou 3, **caractérisé en ce que** l'on produit les signaux (14, 16) d'écho par des gradients (19, 21) de même polarité.

6. Procédé suivant l'une des revendications précédentes, **caractérisé en ce que**, lors de l'enregistrement du premier ensemble de données d'image, on met un nombre plus grand d'impulsions (13) de refocalisation dans un train d'échos que lors de l'enregistrement du deuxième ensemble de données d'image.

7. Procédé suivant l'une des revendications précédentes, **caractérisé en ce que** l'on minimise le temps (TE) d'écho et/ou le temps (TE$_{eff}$) d'écho effectif et/ou le temps (TI) entre les échos dans la première séquence (30) d'écho de turbospin.

8. Procédé suivant l'une des revendications précédentes, **caractérisé en ce que** la différence des temps (TE$_{eff}$) d'écho effectifs entre la première séquence (30) d'écho de turbospin et la deuxième séquence (32, 33) d'écho de turbospin est inférieure ou égale au temps ($\Delta t_{in\text{-}opp}$), dont ont besoin les spins des espèces de spin pour passer de la position en phase à la position en opposition de phase.

9. Procédé suivant l'une des revendications précédentes, **caractérisé en ce qu'**il est effectué sur une installation à résonnance magnétique, avec une intensité de champ plus petite que 1,5 T.

10. Procédé suivant l'une des revendications précédentes, **caractérisé en ce que** l'on enregistre les signaux (14, 15, 16) d'écho par un réseau (3) de bobines.

**11.** Produit (10) de programme d'ordinateur pour un dispositif (8) de commande pour la commande d'une unité de production de données, notamment d'une unité de production d'images, d'une installation (1) à résonnance magnétique, comprenant des instructions, qui, lors de l'exécution du programme par le dispositif de commande, font qu'elles effectuent un procédé suivant l'une des revendications précédentes.

**12.** Support (9) de données pour un dispositif (8) de commande pour la commande d'une unité de production de données, notamment une unité de production d'images, d'une installation (1) à résonnance magnétique, comprenant des instructions qui, lors de la réalisation du programme par le dispositif de commande, font qu'elles effectuent un procédé suivant l'une des revendications 1 à 10.

**13.** Installation (1) à résonnance magnétique, comprenant un dispositif (8) de commande, **caractérisé en ce que** le dispositif (8) de commande est constitué pour effectuer un procédé suivant l'une des revendications 1 à 10.

FIG 1

EP 3 483 618 B1

FIG 2

FIG 3

FIG 4

FIG 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102014215896 B3

**In der Beschreibung aufgeführte Nicht-Patentliteratur**

- **HOLGER EGGERS et al.** Chemical shift encoding-based water-fat separation methods. *JOURNAL OF MAGNETIC RESONANCE IMAGING,* 21. Januar 2014, vol. 40 (2), 251-268

- **ANANTH J. MADHURANTHAKAM et al.** T2-weighted 3D fast spin echo imaging with water-fat separation in a single acquisition. *JOURNAL OF MAGNETIC RESONANCE IMAGING,* 27. August 2010, vol. 32 (3), 745-751